Europäisches Patentamt

European Patent Office

Office européen des brevets

(11) Veröffentlichungsnummer: **0 376 060**
**A1**

## (12) EUROPÄISCHE PATENTANMELDUNG

(21) Anmeldenummer: **89123002.1**

(22) Anmeldetag: **13.12.89**

(51) Int. Cl.5: **C25D 13/02, H01L 39/24**

(30) Priorität: **24.12.88 DE 3843832**

(43) Veröffentlichungstag der Anmeldung:
**04.07.90 Patentblatt 90/27**

(84) Benannte Vertragsstaaten:
**CH DE FR GB LI SE**

(71) Anmelder: **Asea Brown Boveri**
**Aktiengesellschaft**
**Kallstadter Strasse 1**
**D-6800 Mannheim 31(DE)**

(72) Erfinder: **Rohr, Franz-Josef, Dr.**
**Forstweg 2**
**D-6941 Absteinach(DE)**
Erfinder: **Chu, Wing Fong, Dr.**
**Falkensteiner Strasse 61**
**D-6000 Frankfurt 1(DE)**

(74) Vertreter: **Rupprecht, Klaus, Dipl.-Ing. et al**
**c/o Asea Brown Boveri Aktiengesellschaft**
**Zentralbereich Patente Postfach 100351**
**D-6800 Mannheim 1(DE)**

(54) Verfahren zur Herstellung eines Supraleiters.

(57) Die Erfindung bezieht sich auf ein Verfahren zur Herstellung eines Supraleiters (1) aus einem oxidkeramischen Werkstoff, der auf einen Träger (2) aufgetragen wird. Aufgabe der Erfindung ist es, den Träger (2) mit einer sehr dichten, gleichmäßigen supraleitenden Schicht (3) zu versehen.

Erfindungsgemäß kann zur Ausbildung des Supraleiters (1) ein Träger (2) verwendet werden, der aus einem elektrisch leitenden oder elektrisch nicht leitenden Material hergestellt ist. Erfindungsgemäß wird die supraleitende Schicht (3) durch elektrophoretisches Abscheiden der Suspension auf der Oberfläche (2S) des Trägers (2) ausgebildet. Bei Verwendung eines nicht elektrisch leitenden Trägers (2) wird auf der Oberfläche (2S) desselben zunächst ein elektrisch leitender Überzug (4) ausgebildet.

Fig.1

EP 0 376 060 A1

## Verfahren zur Herstellung eines Supraleiters

Die Erfindung bezieht sich auf ein Verfahren zur Herstellung eines Supraleiters gemäß dem Oberbegriff des Patentanspruches 1.

Supraleiter kommen vor allem in der Energietechnik zur Anwendung. Sie sind für die Weiterentwicklung im Bereich der Kernfusion, der supraleitenden Generatoren sowie dem Bau von Starkfeldmagneten erforderlich. Supraleiter werden vorzugsweise als Drähte, Fasern, Bändern, Folien, Rohre, Körper mit Kapillarstruktur oder Körper mit Wabenstruktur bzw. in Form von Platten ausgebildet. Seit langem werden Supraleiter aus Metallen der D-Metallreihe und aus Metallen, die am Anfang der P-Reihe stehen, hergestellt. Seit kurzem ist es auch möglich, Supraleiter aus keramischen Werkstoffen zu fertigen. Es handelt sich dabei um oxidkeramische Materialien mit Perowskitstruktur oder ähnlicher Kristallstruktur, die supraleitende Eigenschaften aufweisen. Diese oxidkeramischen Werkstoffe werden auf einem metallischen oder nichtmetallischen Träger abgeschieden, der eine definierte mechanische Festigkeit und eine ausreichende Flexibilität aufweist.

Ein Nachteil der bisher mit oxidkeramischen Werkstoffen gebildeten supraleitenden Schichten auf Trägern besteht darin, daß die gleichmäßige Ausbildung von dichten Schichten kaum möglich ist, wenn man zu ihrer Herstellung von einem feinkörnigen Pulver des oxidkeramischen Werkstoffs oder einer Suspension des Pulvers ausgeht.

Der Erfindung liegt deshalb die Aufgabe zugrunde, ein Verfahren aufzuzeigen, mit dem auf einem Träger zur Bildung eines Supraleiters eine sehr dichte, gleichmäßig ausgebildete Schicht aus der Suspension des feinkörnigen oxidkeramischen Materials abgeschieden werden kann.

Diese Aufgabe wird erfindungsgemäß durch die Merkmale des Patentanspruches 1 gelöst.

Durch das Auftragen des oxidkeramischen Werkstoffs aus einer Suspension mittels eines elektrischen Feldes, wobei der Träger als Kathode dient, und die Anode dem Träger gegenüber oder um den Träger herum angeordnet wird, können sehr dichte Schichten aus supraleitendem Material gebildet werden, die eine gleichmäßige Stärke aufweisen. Voraussetzung ist jedoch, daß die Oberfläche des Trägers elektrisch leitend und mit dem abzuscheidenden oxidkeramischen Supraleitermaterial hinsichtlich der chemischen und kristallphysikalischen Eigenschaften kompartibel ist. Die Suspension für die Ausbildung des supraleitenden Materials wird durch Vermischen von pulverförmigem oxidkeramischem Werkstoff (Korngröße 3 $\mu$m) wird mit einem Alkohol unter Zusatz einer Zellulose gebildet. Für die Ausbildung der Supraleiter können Träger verwendet werden, die aus einem elektrisch leitenden oder einem elektrisch nicht leitenden Werkstoff hergestellt sind. Bei Verwendung von Trägern der letztgenannten Art wird vor dem Aufbringen der supraleitenden Schicht die Oberfläche des Trägers mit einer elektrisch leitenden Schicht versehen. Dies kann durch Metallisierung der Oberfläche erfolgen. Wegen der erforderlichen Kompatibilität ist es jedoch vorteilhafter, auf die Oberfläche des Trägers ein dünne Schicht der oben beschriebenen Suspension auf zutragen und diese in entsprechender Weise zu behandeln, derart, daß eine dünne elektrisch leitende Schicht von 5 bis 20 $\mu$m gebildet wird. Hiermit kann der ursprünglich nicht leitenden Träger als Kathode für die Abscheidung des oxidkeramischen Materials verwendet werden.

Weitere erfindungswesentliche Merkmale sind in den Unteransprüchen gekennzeichnet.

Das Verfahren und der mit ihm hergestellte Supraleiter werden anhand von Figuren näher erläutert.

Es zeigen:

Figur 1: einen flächig ausgebildeten Supraleiter mit einem Band oder einer Folie als Träger,

Figur 2: einen Supraleiter mit einer Faser als Träger.

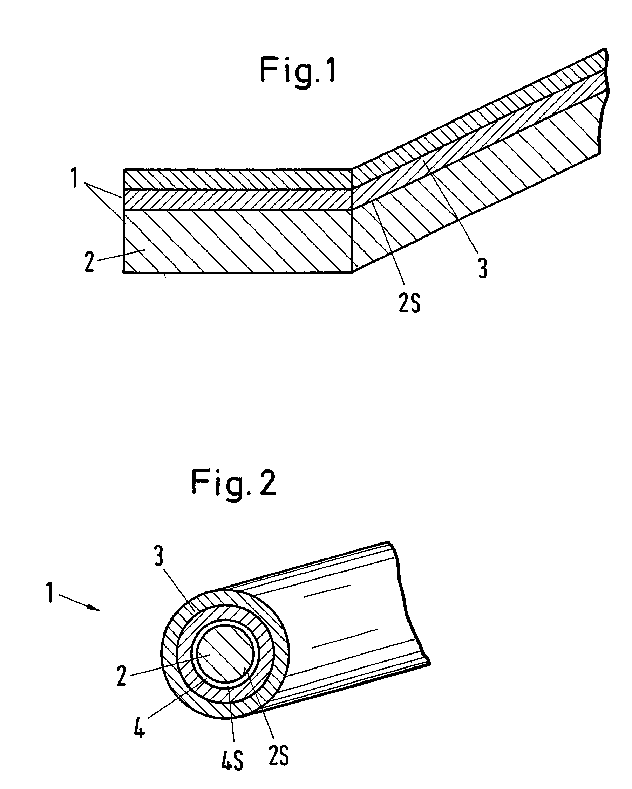

Der in Figur 1 dargestellte Supraleiter 1 wird im wesentlichen durch einen Träger 2 und eine supraleitende Schicht 3 gebildet. Der Träger 2 ist bei dem hier dargestellten Ausführungsbeispiel als flächiges Bauelement ausgebildet. Er ist aus einer Nickel/Chrom-Legierung gefertigt. Träger aus nicht leitenden Werkstoffen und mit einer anderen Form sind selbstverständlich ebenfalls für die Ausbildung eines Supraleiters verwendbar. Die supraleitende Schicht 3 wird durch ein oxidkeramisches Material mit Perowskitstruktur oder ähnlicher Kristallstruktur gebildet, das supraleitende Eigenschaften aufweist. Zur Ausbildung dieser supraleitenden Schicht wird zunächst ein pulverförmiges oxidkeramisches Material, z.B. der bekannten Zusammensetzung $YBa_2Cu_3O_{7-x}$ hergestellt. Als Ausgangswerkstoffe hierfür werden pulverförmiges Yttriumoxid, Bariumperoxid und Kupferoxid verwendet. Die oxidischen Verbindungen von Yttrium, Barium und Kupfer werden in einem Molverhältnis 1:2:3 miteinander gemischt und gemahlen. Anschließend wird das so gewonnene Basismaterial durch Pressen bei einem Druck von 100 MPa verdichtet und daraufhin bei 950 °C etwa 4 Stunden lang an Luft gesintert. Das Sintermaterial wird in einer Sauerstoffatmosphäre oder in Luft langsam abgekühlt, und zwar mit einer Abkühlgeschwindigkeit von etwa 100° pro Stunde bis eine Temperatur von etwa 400 bis 500 °C erreicht ist. Auf dieser Temperatur wird der Sinterwerkstoff nun 4 bis 16 Stunden lang gehalten, je nach Temperatur, und dabei in Luft oder Sauerstoff getempert. Zur Ausbildung des für die Herstellung der Suspension bestimmten Werkstoffes wird das gesinterte und getemperte Material in einer Kugelmühle oder Schwingmühle zu einem feinkörnigen Pulver mit einer Korngröße unter 3 $\mu$m gemahlen. Anschließend wird das Pulver mit einem Suspensionsmittel und einem weiteren Zusatz gemischt. Als Suspensionsmittel wird ein Alkohol vorzugsweise Penthanol, Hexanol oder Butoxyäthanol verwendet. Als Zusatz wird der Suspension Äthylzellulose beigemischt. Das oxidkeramische Material, das Suspensionsmittel und der Zusatz werden miteinander vermischt. Das Auftragen des oxidkeramischen Materials auf den Träger 2 erfolgt nach dem Prinzip der Elektrophorese durch Anlegen eines elektrischen Feldes. Der mit einer elektrisch leitenden Oberfläche ausgestattete Träger 2 wird in diesem Fall als Kathode genutzt. Die zu beschichtende Oberfläche wird der als Anode dienenden Elektrode gegenüberliegend angeordnet. Der Abstand zwischen Kathode und Anode sollte zwischen 2,5 und 3,1 cm liegen. Zwischen Anode und Kathode wird ein elektrisches Feld von etwa 100 V/cm ausgebildet. Anode und Kathode sind innerhalb der Suspension (hier nicht dargestellt) angeordnet. Diese wird vor dem elektrophoretischen Abscheiden etwa 15 Minuten lang mit Ultraschallwellen behandelt. Nach dem Auftragen der Schicht 3 auf den Träger 2 ist der Supraleiter bis auf eine thermische Nachbehandlung fertiggestellt. Als Träger kann anstelle eines flächigen Bauelements auch ein Träger in Form eines Drahtes oder einer Faser verwendet werden.

Ein Supraleiter 1 mit einem faserförmigen Träger 2 ist in Figur 2 dargestellt. Als Träger 2 dient, z.B. eine keramische Faser aus Zirkonoxid oder Aluminiumoxid oder eine Glasfaser, deren Oberfläche zunächst mit einer elektrisch leitenden Schicht zu versehen ist, damit der Träger 2 zum Auftragen der supraleitenden Schicht 3 als Kathode verwendet werden kann. Hierfür kann die gesamte Oberfläche des Trägers 2 mit einer elektrisch leitenden Schicht aus Kupfer, Nickel oder einem Edelmetall wie Silber oder Platin überzogen werden. Das Gleiche ist anzuwenden, wenn bspw. der Träger aus Zirkoniumdioxid oder einem Alphaaluminiumoxid hergestellt ist. Es besteht die Möglichkeit, anstelle eines Überzuges 4 aus einem reinen Metall auf der Oberfläche des Trägers 2 einen Überzug 4 aus der Suspension durch Aufsprühen, durch Tauchen oder mittels Siebdruck aufzubringen. Dieser aufgetragene Überzug 4 wird dann bei 150 °C getrocknet und anschließend ca. 15 Minuten auf 1100 °C bis 1300 °C erhitzt. Das Ganze geschieht in Luft. Falls es erforderlich ist, kann die Suspension auf gleiche Weise nochmals aufgetragen werden. Der dabei gebildete Überzug 4 weist eine für die Elektrophorese ausreichende spezifische elektrische Leitfähigkeit von $\rho \leq 0,001$ Ohm x m auf. Der Träger 2 ist nunmehr geeignet als Kathode für eine elektrophoretische Abscheidung verwendet zu werden.

Bei faserförmig ausgebildeten Trägern 2, wie es hier der Fall ist, wird eine ringförmige Anode verwendet, die im Abstand von 2,5 bis 3,1 cm um die Kathode angeordnet ist. Vor der elektrophoretischen Abscheidung wird die Suspension, deren Zusammensetzung eingangs erläutert ist, und die auch zur Ausbildung des elektrisch leitenden Überzuges 4 auf dem Träger 2 verwendet wird, etwa 15 Minuten lang mit Ultraschall behandelt. Anschließend wird zwischen dem Träger 2 und der Anode (hier nicht dargestellt), die beide in der Suspension (hier nicht dargestellt) angeordnet sind, ein elektrisches Feld von 100 V/cm ausgebildet. Nach dem Abscheiden der supraleitenden Schicht 3 auf der Oberfläche 4S des Überzuges 4 erfolgt eine thermische Nachbehandlung von 4 Stunden bei 950 °C in Luft. Anschließend wird der Supraleiter 1 mit einer Abkühlgeschwindigkeit von 1 °C pro Minute auf 500 °C abgekühlt und bei dieser Temperatur ca. 10 Stunden in Luft oder Sauerstoff getempert.

## Ansprüche

1. Verfahren zur Herstellung eines Supraleiters (1) aus einem oxidkeramischen Werkstoff, der auf einen Träger (2) aufgetragen ist, dadurch gekennzeichnet, daß zur Ausbildung der supraleitenden Schicht (3) die Abscheidung des oxidkeramischen Werkstoffs auf den Träger (2) durch Anlegen eines elektrischen Feldes erfolgt.

2. Verfahren nach Anspruch 1, dadurch gekennzeichnet, daß zur Ausbildung der supraleitenden Schicht (3) pulverförmiges, oxidkeramisches Material mit einer Korngröße kleiner 3 $\mu$m mit einem Suspensionsmittel und einem Zusatz vermischt wird, und daß diese Suspension kurz vor der elektrischen Abscheidung eine definierte Zeit mit Ultraschall behandelt wird.

3. Verfahren nach Anspruch 2, dadurch gekennzeichnet, daß zur Ausbildung der supraleitenden Schicht (3) der oxidkeramische Werkstoff mit einem Alkohol in Form von Penthanol, Hexanol oder Butoxyäthanol und einem Zusatz von Äthylzellulose zu einer Suspension vermischt wird.

4. Verfahren nach einem der Ansprüche 1 bis 3, dadurch gekennzeichnet, daß zur Ausbildung der supraleitenden Schicht (3) der Träger (2) als Kathode genutzt wird, und daß zwischen der im Abstand von 2,8 bis 3,1 cm von der Kathode angeordneten Anode ein elektrisches Feld von 95 bis 110 V/cm ausgebildet und dadurch der oxidkeramische Werkstoff aus der Suspension elektrophoretisch auf dem Träger (2) abgeschieden wird.

5. Verfahren nach einem der Ansprüche 1 bis 4, dadurch gekennzeichnet, daß zur Ausbildung der supra leitenden Schicht (3) bei Verwendung eines Trägers (2) aus einem nicht leitenden Werkstoff, zunächst eine dünne ers leitende Schicht (4) des oxidkeramischen Werkstoffs auf der Oberfläche (25) des Trägers (2) aufgebracht und anschließend die supraleitende Schicht (3) durch elektrophoretische Abscheidung des oxidkeramischen Werkstoffs aus einer feinkörnigen Suspension darauf abgeschieden wird.

6. Verfahren nach Anspruch 5, dadurch gekennzeichnet, daß zur Ausbildung der supraleitenden Schicht (3) auf einem Träger (2) aus einem nicht elektrisch leitenden Werkstoff dessen Oberfläche (25) zunächst mit der für die supraleitende Schicht (3) vorgesehenen Suspension bepinselt oder in selbige eingetaucht bzw. diese durch Siebdruck auf die Oberfläche (25) aufgetragen wird, und daß die so aufgetragene Suspension zur Ausbildung des elektrisch leitenden Überzuges (4) bei 150 °C getrocknet und anschließend 15 Minuten auf 1100 bis 1300 °C erhitzt wird.

7. Verfahren nach einem der Ansprüche 1 bis 6, dadurch gekennzeichnet, daß zur Ausbildung der surpaleitenden Schicht (3) oxidkeramisches Material mit der Zusammensetzung $Y_1Ba_2Cu_3O_x$ mit Alkohl in Form von Penthanol, Hexanol oder Butoxyäthanol und einem Zusatz von Äthylzellulose zu einer Suspension vermischt und durch elektrophoretische Abscheidung unmittelbar auf der Oberfläche (2S) oder auf dem Überzug (4) des Trägers (2) abgeschieden wird, und daß der Träger (2) mit der aufgetragenen Suspension bei 150 °C getrocknet und anschließend für 2 Stunden bei 950 °C in Luft gesintert, dann mit einer Abkühlgeschwindikeit von 1 °/Minute auf 500 °C abgekühlt und bei dieser Temperatur ca. 10 Stunden in Luft oder Sauerstoff getempert wird, derart, daß x einen Wert zwischen 6,8 und 6,95 annimmt.

# Fig.1

1

2

2S

3

# Fig.2

3

1

2

4

4S   2S

## EUROPÄISCHER RECHERCHENBERICHT

**Europäisches Patentamt**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 289 412 (IWATA)<br>* Spalte 11, Beispiel 8 *<br>--- | 1,4,5 | C 25 D 13/02<br>H 01 L 39/24 |
| X | EP-A-0 293 981 (IMI TITANIUM LTD)<br>* Spalte 6, Zeilen 8-43; Spalte 5, Zeile 20 *<br>----- | 1,5 | |

RECHERCHIERTE SACHGEBIETE (Int. Cl.5)

C 25 D
H 01 L

Der vorliegende Recherchenbericht wurde für alle Patentansprüche erstellt

| Recherchenort | Abschlußdatum der Recherche | Prüfer |
|---|---|---|
| DEN HAAG | 28-03-1990 | NGUYEN THE NGHIEP |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)